Europäisches Patentamt

European Patent Office

Office européen des brevets

(19)

(11) Publication number: 0 641 150 A1

(12) **EUROPEAN PATENT APPLICATION**
published in accordance with Art. 158(3) EPC

(21) Application number: 93910327.1

(22) Date of filing: 12.05.93

(86) International application number:
PCT/JP93/00622

(87) International publication number:
WO 93/23978 (25.11.93 93/28)

(51) Int. Cl.⁶: H05H 1/46, C23C 14/00, C23C 16/00, H01L 21/302, H01L 21/205

(30) Priority: 13.05.92 JP 146332/92

(43) Date of publication of application:
01.03.95 Bulletin 95/09

(84) Designated Contracting States:
DE GB NL

(71) Applicant: OHMI, Tadahiro
1-17-301, Komegabukuro 2-chome
Aoba-ku
Sendai-shi
Miyagi-ken 980 (JP)

(72) Inventor: OHMI, Tadahiro
1-17-301, Komegabukuro 2-chome
Aoba-ku
Sendai-shi
Miyagi-ken 980 (JP)

(74) Representative: Weitzel, Wolfgang, Dr.-Ing.
Friedenstrasse 10
D-89522 Heidenheim (DE)

(54) **PROCESS APPARATUS.**

(57) A process apparatus whose chamber can be cleaned in a short time not exposed to air at all. At least two electrodes of first and second electrodes (107, 105) are provided in a vacuum vessel (108). A high-frequency power (112) having a first frequency is supplied to the first electrode (107), and a high-frequency power (101) having a second frequency different from the first frequency is supplied to the second electrode (105). A mechanism for supporting a wafer (106) is disposed on the second electrode (105), and a gas introduced into the vacuum vessel (108) is turned into a plasma by the powers. In this apparatus, a mechanism, by which the impedance between the second electrode (107) and a ground can be made enough larger than that between the first electrode and the ground, if necessary, is provided.

Fig. 1

## Technical Field

This invention relates to a process apparatus. In more detail, it relates to a process apparatus having a high performance provided with a self cleaning mechanism.

## Background Art

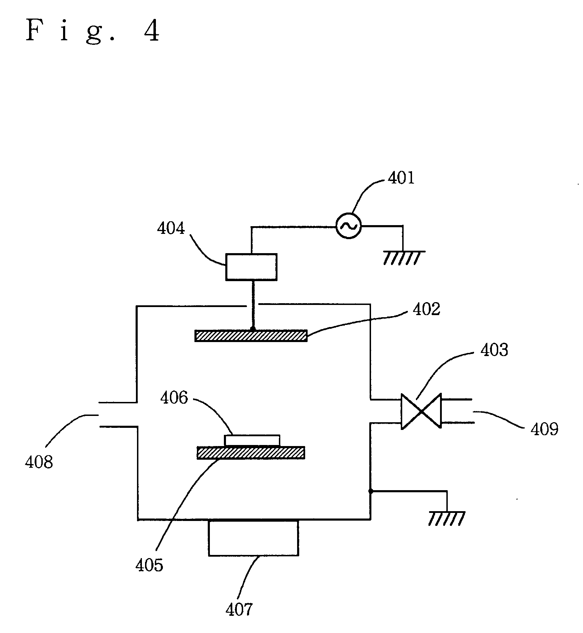

The prior art will be described with reference to Fig. 4.

Fig. 4 is a sectional view of a vacuum vessel of a general plasma CVD apparatus.

In Fig. 4, numeral 401 depicts a high-frequency generating apparatus, 402 an upper electrode, 403 a valve, 404 a high-frequency matching circuit, 405 a lower electrode, 406 a wafer, 407 a heater for heating the wafer, 408 a gas inlet, and 409 an evacuating port.

In this apparatus, the wafer surface is accumulated thereon, for example, with $SiO_2$ film, a method of which is to dispose the wafer 406 on the lower electrode through a gate valve from another vacuum vessel (not shown). The wafer 406 is heated, for example, at about 400°C by the heater 407, and monosilane gas and oxygen gas are introduced thereto from the gas inlet 408. By means of the high-frequency generating apparatus 401, a high-frequency electric power, for example, having a frequency of 13.56 MHz is supplied on the upper electrode 402 to produce a plasma, then $SiO_2$ is accumulated on the wafer surface. At this time, the $SiO_2$ sticks not only on the wafer surface but also entirely on all inside surfaces of the vacuum vessel. The $SiO_2$ stucked on the inside surface of the vacuum vessel increases with the increase of the number of sheets of wafers processed, thus it separates and then sticks on the wafer surface, a production yield is considerably lowered, for example, in semiconductor manufacturing.

To solve this problem, substances stucked on the inside surfaces of the vacuum apparatus are required to be removed by cleaning.

A method of cleaning in the prior art includes a wet cleaning and a dry cleaning, which are described as follows.

In the wet cleaning, the control proceeds to turn OFF the power supply to the heater 407, to lower a temperature of the lower electrode down to a room temperature, thereafter to closing the valve 403 of the evacuating port, and to introduce argon gas or nitrogen gas from the gas inlet 408. By thus introduced gas, an inside of the vacuum vessel is made into an atmospheric pressure from vacuum. After the inside of the vacuum vessel comes into the atmospheric pressure, gas supply from the gas inlet 408 is stopped and a cover (not shown) of the vacuum vessel is removed. Organic solvent such as isopropyl alcohol or ethanol or the like is suitably impregnated into cloth hardly generating particles, and after the cloth is used to completely wipe and clean every nook and corner of the inside surface of the vacuum vessel, the cover is assembled on the vacuum vessel. Here, the control proceeds to open the valve 403 of the evacuating port, to evacuate the vacuum vessel, and to give a predetermined temperature to the lower electrode by turning ON the power supply of the heater 407. Furthermore, it is confirmed that a vacuum degree inside the vacuum vessel is equal to or less than a predetermined background.

In the dry cleaning, inert gas containing halogen group atoms such as F, Cl, and Br is introduced from the gas inlet 408 to produce a predetermined pressure inside the vacuum vessel. The high-frequency electric power having, for example, a frequency of 13.56 MHz is supplied to the upper electrode 402 by using the first high-frequency generating apparatus 401, thereby plasma is produced to chemically activate the halogen group atoms. Thus activated halogen group atoms react with impurities stucked on the inside surface of the vacuum vessel to be converted into gas phase, which is removed by an evacuating apparatus.

Each of the prior art described above has a problem as follows.

In the wet cleaning, a large problem resides in that substances stucked on the inside surface of the vacuum vessel are wiped and cleaned under the atmospheric pressure by the cloth in which organic solvent such as isopropyl alcohol or ethanol is impregnated. In detail, such wiping and cleaning works are performed under the atmospheric pressure, thereby moisture in the atmosphere sticks on the inside surface of the vacuum vessel, or the organic solvent impregnated into the cloth remains inside the vacuum vessel, or further, particles generated from the cloth are left inside the vacuum vessel. These residual impurities, when processing, provide disadvantages in contaminating the wafer, and in deteriorating a characteristic of the semiconductor device and so forth.

In the dry cleaning, plasma generated in the vacuum vessel is impossible to remove impurities stucked in every nook and corner of the inside of the vacuum vessel because of an insufficient spread of the plasma into the vacuum vessel. For this reason, in the event of increasing the amount of impurity or impurities stucked on the inside surface of the vacuum vessel, finally, the wet cleaning has still been reliable which however includes the disadvantages as formerly described.

As described above in the prior art, the particles or impurities remain inside the vacuum vessel, this lowers production yield in manufacturing semiconductors etc.

In addition, these cleaning works provide a serious problem in considerably deteriorating an availability factor or a rate of operation of the apparatuses and in degrading a production efficiency in the manufacturing process lines.

An object of the invention is to provide a process apparatus capable of cleaning in a short time entirely without exposing a chamber into the atmosphere.

## Disclosure of the Invention

An apparatus according to the present invention, in which at least two electrodes, first and second electrodes are provided in a vacuum vessel, a high-frequency electric power having a first frequency is supplied to the first electrode, a high-frequency electric power having a second frequency different from the first frequency is supplied to the second electrode, a mechanism for holding a wafer is disposed on the second electrode, and a gas introduced into the vacuum vessel is turned into a plasma, is characterized by having a structure by which an impedance between the second electrode and the earth is made larger enough than that between the first electrode and the earth, if necessary.

## Function

A structure, in which an impedance across a second electrode and the earth is made larger enough than an impedance across a first electrode and the earth, is operated, thereby plasma within a vacuum vessel spreads, chemically activated halogen group atoms are spread in every nook and corner inside the vacuum vessel to react with impurities stucked on the inside surface of the vacuum vessel and to be turned into gas phase, which is removed by an evacuating apparatus.

As a consequence, the impurities are removed up to an extent in every nook and corner of the inside of the vacuum vessel.

## Brief Description of the Drawings

Fig. 1 is a typical view of a vacuum vessel of a semiconductor process apparatus according to a first embodiment.

Fig. 2 is a typical view of a vacuum vessel of a semiconductor process apparatus according to a second embodiment.

Fig. 3 is a graphical representation showing a relationship between ion energy (Eion) on exciting $CCl_4$ and a flux parameter.

Fig. 4 is a typical view of the vacuum vessel of the semiconductor process apparatus according to the prior art.

Reference numeral 101 depicts a first high-frequency generating apparatus, 102 a first high-frequency matching circuit, 103 a gas inlet, 104 an evacuating port, 105 an upper electrode, 106 a target of silicon, 107 a lower electrode, 108 a vacuum vessel, 109 a flange, 110 a coil, 111 a second high-frequency matching circuit, 112 a second high-frequency generating apparatus, 113 a band-pass filter, 114 a turn switch, and 201 a capacitor.

## Best Mode for Carrying Out the Invention

One embodiment according to the present invention is described referring to the drawings as follows.

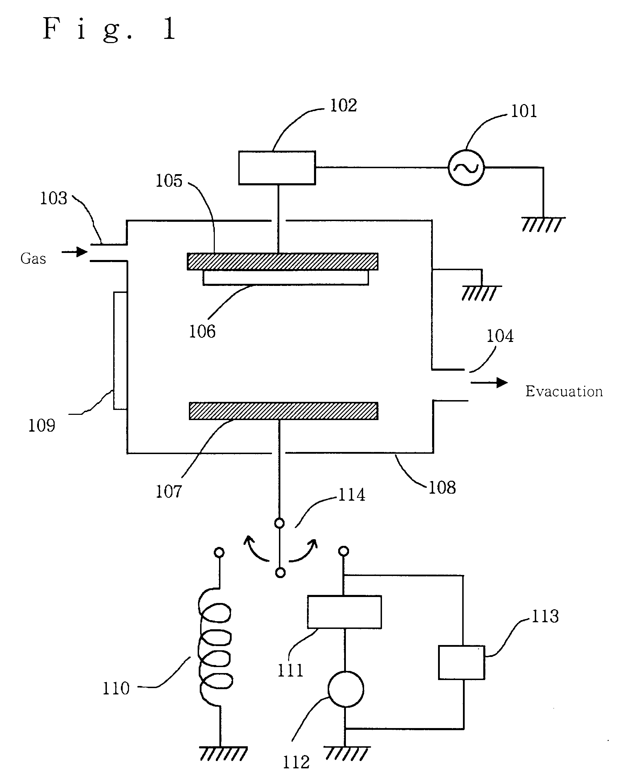

Fig. 1 is a sectional view of an apparatus showing a first embodiment. In Fig. 1, 101 depicts a high-frequency generating apparatus, for example, having a frequency of 13.56 MHz, which is connected to an upper electrode 105. 102 depicts a high-frequency matching circuit. 103 depicts a gas inlet, for example, with a bore diameter of 1/4 inches, which is made of material SUS316L and whose inside surface is processed of complex electolytic polishing and oxide passivation processing. Gas for cleaning uses, for example, $CF_4$, and gas for wafer process uses, for example, monosilane gas or oxygen gas. 106 depicts a target material which uses, for example, a silicon wafer with a diameter of 5 inches.

Numeral 108 depicts a depressurisable vacuum vessel, for example, whose material is SUS316L and inside surface is processed of the complex electrolytic polishing and the oxide passivation processing and one edge is formed in a hollowed 300mm cubic box shape.

Numeral 104 depicts an evacuating port for evacuating the vacuum vessel 108, an evacuating apparatus uses, for example, a turbo molecular drag pump. 109 is a flange, for example, whose material is SUS316L and inside surface is processed of the complex electrolytic polishing and the oxide passivation processing and which is formed into a disk shape with a diameter of 200 mm.

Numerals 105 and 107 depict upper and lower electrodes respectively, for example, each having material of SUS316L whose surface is processed of the complex electrolytic polishing and the oxide passivation processing and whose largeness is of a diameter of 6 inches. 112 depicts a high-frequency generating apparatus, for example, having a frequency of 35 MHz which is connected to the lower electrode 107. 111 depicts a high frequency matching circuit thereof. 113 depicts a band pass filter whose circuit is made of a coil and a capacitor and which makes the lower electrode a short circuit in a high-frequency manner for a first frequency, for example, 13.56 MHz on wafer processing. 110 depicts a coil, for example, made of copper as a material, having a copper wire outer-diameter 1 mm, a coil radius of 25 mm, a coil length of 300 mm, and the number of coil turns 145. This is equal to about $1.6 \times 10^{-4}$ H with an impedance 100 kΩ for 100 MHz. 114 depicts a turn switch for connecting the lower electrode 107 to the high-frequency generating power supply 112-side or the coil 110-side.

Followingly, functions of the apparatus are described. In this apparatus, for example, Si sputtering is available. To achieve this, a silicon wafer is disposed on the lower electrode 107 through a gate valve from a vacuum vessel (not shown) connected to the vacuum vessel 108. The turn switch 114 is connected to the high-frequency generating apparatus 112 side, argon gas is introduced into the vacuum vessel 108 from the gas inlet 103 and a high-frequency electric power having a frequency of 1 to 15 MHz (13.56 MHz in this example) is applied to the upper electrode 105 from the high-frequency apparatus 101, thereby a plasma is generated in the vacuum vessel 108. At this time, a wafer (not shown) set on the lower electrode 107 is heated by the heater, for example, at 300°C, and silicon target material 106 is biased, for example, by -300 V from the external for the earth (not shown). In this embodiment, the target material is biased, for example, using current in a direct-current. However, the foregoing is unnecessary depending on a frequency or a high-frequency electric power. Such is the case, argon ion within the plasma sputters the silicon target material 106, thus sputtered Si is accumulated on the wafer which is disposed on the lower electrode 107. In this case, by the high-frequency generating apparatus 112, preferably a high-frequency electric power having a frequency of 30 to 50 MHz (35 MHz in this example) is supplied to the lower electrode 107 to self bias the wafer, for example, by +10 V, then Si accumulated on the wafer comes to monocrystal, thus monocrystallization of Si at a low temperature is possible.

However, thus sputtered Si sticks on everywhere on the inside surface of the vacuum vessel 108 even in the present apparatus. As hereinbefore described in the prior art paragraph, such must be removed.

The examples of cleaning of the vacuum vessel 108 include the followings.

The turn switch 114 is connected to the coil 110 side, and the gas, for example $CF_4$, is introduced from the gas inlet 103, and by the first high-frequency generating apparatus 101 a high-frequency electric power having, for example, a frequency of 100 MHz is imposed on the upper electrode 105 to generate plasma in the vacuum vessel 108. Then, the plasma spreads enough in the vacuum vessel 108 and impurity stucked in every nook and corner of the surface can be removed.

A reason why the plasma spreads into the vacuum vessel 108 in the embodiment is described as follows. The first high-frequency on cleaning uses, for example, 100 MHz, and for such 100 MHz, the vacuum vessel 108 has an impedance of 100 Ω for the effective earth. An impedance across the lower electrode and the earth is equal to 100 kΩ in this embodiment because the turn switch 114 is connected to the coil side on cleaning. Thus, when applying a high-frequency electric power on the upper electrode 105 by the first high-frequency generating apparatus 101, a high-frequency current hardly flows into the lower electrode 107, but easily flows into the inside wall of the vacuum vessel, this enables the plasma to spread.

As hereinbefore described, in this embodiment, impurities stucked on the inside surface of the vacuum vessel 108 can be removed without opening of the vacuum vessel 108 to the atmosphere, hence, moisture in the atmosphere is not to stick on the inside surface of the vacuum vessel 108, or the inside of the vacuum vessel 108 is not to be contaminated due to dust from the cloth used on wet cleaning operation, unlike the wet cleaning described in the prior art paragraph. The organic solvent impregnated in the cloth is not to remain in the vacuum vessel 108. Therefore, in the invention, particles or impurities are not to remain in the vacuum vessel 108, unlike the prior art. This considerably serves in improving production yield in semiconductor manufacturing.

In the embodiment, the extremely shortened time is enough for cleaning, compared to the wet cleaning.

According to the present invention, a rate of operation of the apparatus which is of the same importance as a production yield in the semiconductor manufacturing can largely be upgraded.

In the embodiment, the vacuum vessel 108, gas inlet 103, flange 109, upper electrode 105, and lower electrode 107 are, for example, made of material of SUS316L and formed of inside surfaces and outer surfaces which both are processed of the complex electrolytic polishing and the oxide passivation processing. This is because the inside surface of the vacuum vessel is made prevented from corrosion even in exposed to halogen atoms which are chemically activated on cleaning. Further in the invention, there may preferably be used the other materials, for example, SUS316L, or aluminum processed, for example, of nickel plating, whose surfaces are treated with fluoridation process. In essential, in the invention, any of those without corrosion even in exposed to chemically activated halogen group atoms may preferably be used.

In the embodiment, the turbo molecular drag pump is used for the evacuating apparatus. However according to the invention, it is of course that the other types of vacuum pumps may preferably be used depending on utilizations.

In the embodiment, the silicon wafer with a diameter of 5 inches is used for the target material 106. However in the invention, any of other materials may preferably be utilized depending on utilizations.

In the embodiment as described above, 100 MHz is given to the first frequency of the high-frequency electric power imposed by the first high-frequency generating apparatus 101. In the invention, a frequency equal to or more than 100 MHz may preferable be used (preferably a frequency of 100 to 200 MHz). In case of cleaning by setting 100 MHz or more, an arisen smaller self spurious in the target 106 suppresses sputtering of the target 106 to satisfactorily prevent additional contamination during cleaning of the vacuum vessel.

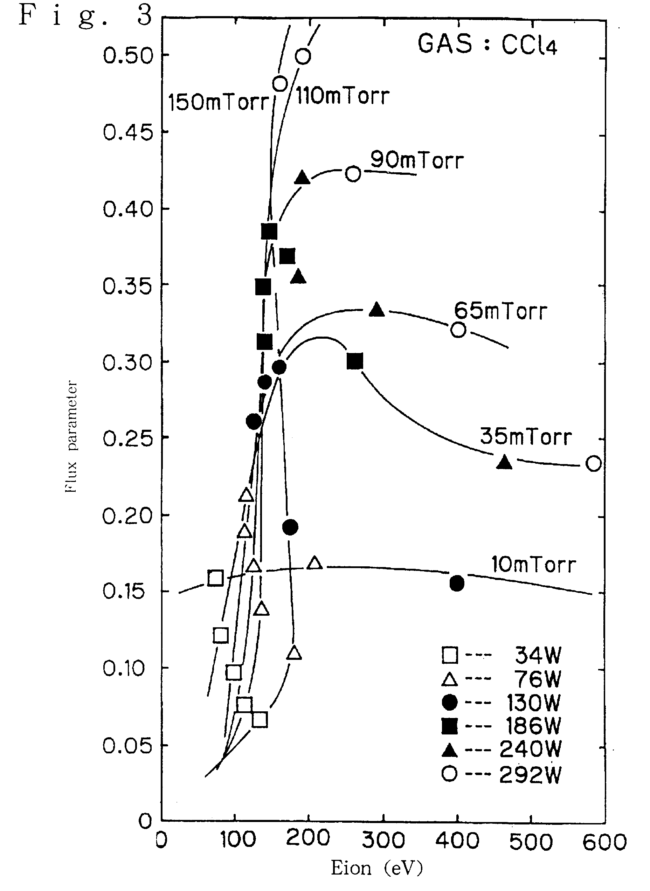

In the embodiment, $CF_4$ is used as an introducing gas from the gas inlet 103. However in the invention, halogen group atoms such as F, Cl, and Br or inert gas similar thereto may preferably be utilized. In particular, in respect of the gas such as $CCl_4$ having smaller binding energy of gas molecules (preferably, equal to or less than 4 eV / Molecule) from among gases, as shown in Fig. 3, a flux parameter expressing a largeness of ion density increases, although the ion energy (Eion) is hardly varied within a range of low value, when allowing the high-frequency electric power to gradually increase under the condition of a cleaning process pressure equal to or more than 110 mTorr in case where plasma is generated by applying the high-frequency electric power having a frequency of 13.56 MHz. The same tendency as described above is obtained in case of 100 MHz or more. Accordingly, it is possible to raise only the ion density while the ion energy remains kept at low value when the high-frequency electric power is increased for effectively performing the cleaning process. Thus, in the cleaning process, impurities on surfaces is effectively removed without damage to, for example, the oxide passivation skin film which is exposed to plasma, for example, which is provided on an inside surface of a vacuum tube or on a front surface of an electrode. For gases other than $CCl_4$ gas, there can be provided $SF_6$, $PCl_3$, $NF_3$, HBr, HI, and $Br_2$.

The flux parameter is defined by the following equation (see Japanese Patent Application Hei-2-252847 in 1990),

$$Flux = Pwrf / Vpp$$

where Pwrf represents a high-frequency electric power supplied to an electrode, and Vpp represents a high-frequency amplitude in the electrode.

In the embodiment, copper as an example for material is used for the coil 110 made of copper wire with a diameter 1 mm, a coil radius of 25 mm, a coil length of 300 mm and the number of coil turns of 145. However in the invention, the other materials and optional shape for the coil may preferably be used depending on utilizations. In essential according to the invention, when connecting the turn switch 114 to the coil 110 side, an impedance between the lower electrode and the earth may preferably be larger enough than that between the upper electrode and the earth. In the embodiment, the fix type is used for the coil inductance. However in the invention, a variable type of coil inductance may preferable be utilized.

The cleaning process of the embodiment may preferably be performed, immediately after wafer processing, every time after the wafer is carried to a vacuum vessel connected through the gate valve to the vacuum vessel 108. In this process, the same conditions within the vacuum vessel 108 are maintained at every time immediately before wafer processing, hence, an stable wafer processing is possible. The cleaning may preferably be performed after several sheets of wafers have been processed.

In the embodiment, as a wafer process, for example, sputtering process of silicon is performed, and in the cleaning process, accumulated substances of silicon stucked on the inside surface of the vacuum vessel is removed. However in the invention, the others as a wafer process, for example, a process such as CVD process or RIE process may preferably be performed to remove accumulated substances, for example, Si, $SiO_2$, fluorine compound, and carbon compound, which have been stucked on the inside surface of the vacuum vessel on cleaning process.

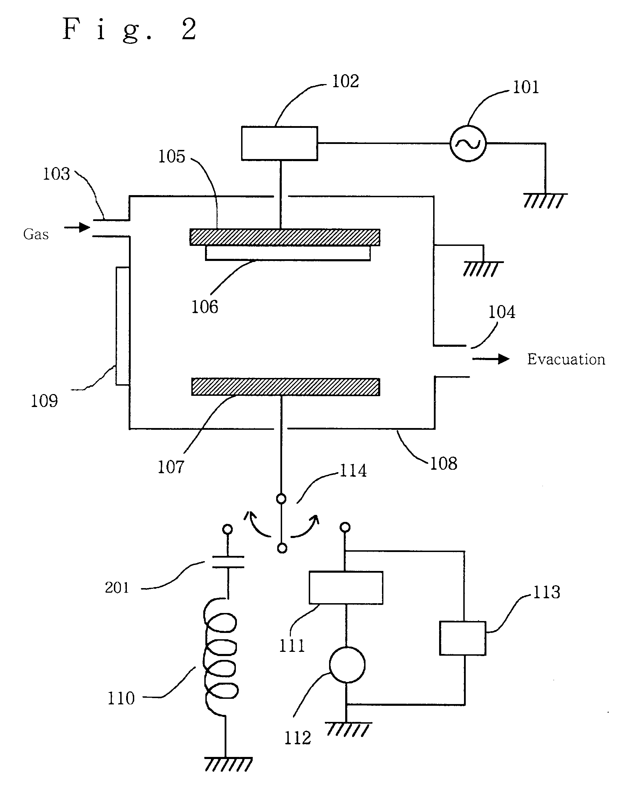

Fig. 2 shows a second embodiment.

This embodiment corresponds to the first embodiment, however in which the capacitor 201 is inserted between the coil 110 and the second electrode 107, where the other construction is the same as in the first embodiment, therefore the explanation thereof will be omitted.

The capacitor 201 with a capacitance of 10 pF is used. As is the case of the first embodiment, when plasma is generated in the vacuum vessel 108, the plasma spreads enough into the vacuum vessel 108, impurities stucked in every nook and corner on the surface can be removed.

In the embodiment, the capacitor 201 with a capacitance of 10 pF is used. However in the invention, the other optional fixed valued capacitance or a variable capacitance may preferable be utilized. In essential, when connecting the turn switch 114 with the coil 110, an impedance between the lower electrode and the earth may preferably be made larger enough than an impedance between the upper electrode and the earth.

Furthermore, in the embodiment, the coil and the capacitor are connected in series with each other. However in the invention, a parallel circuit therefor may be available.

**Industrial Applicability**

The invention is to provide a process apparatus capable of cleaning in a short time entirely without exposing a chamber to the atmosphere.

**Claims**

1. In an apparatus in which at least two electrodes, first and second electrodes are provided in a vacuum vessel, a high-frequency electric power having a first frequency is supplied to the first electrode, a high-frequency electric power having a second frequency different from the first frequency is supplied to the second electrode, a mechanism for holding a wafer is disposed on the second electrode, and a gas introduced into the vacuum vessel is turned into a plasma,

   a process apparatus characterized by having a structure by which an impedance between the second electrode and the earth is made larger enough than that between the first electrode and the earth, if necessary.

2. A process apparatus in accordance with claim 1, wherein a coil or a circuit of combination of a coil and a capacitor is used as a structure for enlarging an impedance between the first electrode and the earth, if necessary.

3. A process apparatus in accordance with claim 1, wherein the gas in said item 1 is an inert gas, for example, a gas having halogen group atoms such as F, Cl, Br.

4. A process apparatus in accordance with claim 1, wherein the first frequency is equal to or more than 100 MHz, and the second frequency is equal to 10 to 50 MHz.

5. A process apparatus in accordance with claim 1, wherein the first frequency is equal to 1 to 15 MHz, and the second frequency is equal to 30 to 50 MHz.

# Ｆｉｇ． 1

# Fig. 2

F i g. 3

F i g .  4

INTERNATIONAL SEARCH REPORT

International application No.

PCT/JP93/00622

**A. CLASSIFICATION OF SUBJECT MATTER**

Int. Cl$^5$   H05H1/46, C23C14/00, 16/00, H01L21/302, 21/205

According to International Patent Classification (IPC) or to both national classification and IPC

**B. FIELDS SEARCHED**

Minimum documentation searched (classification system followed by classification symbols)

Int. Cl$^5$   H05H1/00-1/54, C23C14/00-14/58, 16/00-16/58,
H01L21/302, 21/205, 21/365, 21/31

Documentation searched other than minimum documentation to the extent that such documents are included in the fields searched

Jitsuyo Shinan Koho                    1926 - 1992
Kokai Jitsuyo Shinan Koho              1971 - 1992

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | JP, A, 1-100925 (Hitachi, Ltd.),<br>April 19, 1989 (19. 04. 89), (Family: none) | 1-3<br>4, 5 |
| Y<br>A | JP, A, 57-131374 (Nippon Telegraph &<br>Telephone Public Corp.),<br>August 14, 1982 (14. 08. 82), (Family: none)<br>(Fig. 3) | 1-3<br>4, 5 |
| Y<br>A | JP, A, 62-125626 (Hitachi, Ltd.),<br>June 6, 1987 (06. 06. 87), (Family: none)<br>(Fig. 3) | 1-3<br>4, 5 |

☒ Further documents are listed in the continuation of Box C.        ☐ See patent family annex.

| | |
|---|---|
| *    Special categories of cited documents:<br>"A"   document defining the general state of the art which is not considered to be of particular relevance<br>"E"   earlier document but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| July 30, 1993 (30. 07. 93) | August 17, 1993 (17. 08. 93) |

| Name and mailing address of the ISA/ | Authorized officer |
|---|---|
| Japanese Patent Office | |
| Facsimile No. | Telephone No. |

Form PCT/ISA/210 (second sheet) (July 1992)